# EUROPEAN PATENT APPLICATION

(11) **EP 2 669 409 A1**
(43) Date of publication of application: **04.12.2013**
(21) Application number: 12169779.1
(22) Date of filing: 29.05.2012
(51) Int. Cl.: C30B 7/10, C30B 29/46, C30B 29/60, B82Y 20/00

(54) **Method for preparing highly crystalline Pb chalcogenide nanoparticles, nanoparticles prepared thereby and use thereof**

(71) Applicant: King Saud University, 11421 Riyadh (SA)
(72) Inventor: Rezaul Karim, Mohammad, 11421 Riyadh (SA); Badruz Zaman, Mohammed, 11421 Riyadh (SA); Al-Ahmari, Abdulrahman, 11421 Riyadh (SA)
(74) Representative: Goddar, Heinz J.

(57) **Abstract**

The present invention relates to a method for preparing highly crystalline lead (Pb) chalcogenide nanoparticles, comprising the steps: a) reacting Pb-precursor and oleic acid in a stabilizing solvent to prepare a first solution containing Pb carboxylate, b) preparing a second solution of a sulphur-containing material in the stabilizing solvent, c) preparing a mixture of the first and the second solution and optionally additional stabilizing solvent, and d) transferring the mixture obtained in step c) to a teflon-lined autoclave and keeping the mixture in the closed autoclave at a temperature of about 30°C-150°C highly crystalline Pb chalcogenide nanoparticles obtained thereby and use thereof in optoelectronic devices including photovoltaic.

## Description

The present invention relates to a method for preparing highly crystalline Pb chalcogenide nanoparticles, nanoparticles obtained thereby and the use thereof in semiconducting or optoelectronic devices.

Among semiconductor nanocrystals, PbS, together with other lead chalcogenides including PbSe and PbTe have demonstrated to be the most promising candidates so far in photovoltaic (PV) devices. The PV devices fabricated with lead salts often perform well in relatively high power conversion efficiency (PCE), for example colloidal PbS nanoparticles (NBs) based devices have reached a PCE value of 1.8%, see Johnson, K. W., et al. "Schottky-Quantum Dot Photovoltaics for Efficient Infrared Power Conversion". Appl. Phys. Lett. 2008, 92, 151115. Significant efforts are still ongoing with the lead chalcogenide nanoparticles targeting even higher PCEs.

It is interesting to note that nearly all previous reports and ongoing efforts for PV device studies by using PbS nanoparticles, the high quality PbS materials have been exclusively prepared by using PbO and expensive, air sensitive and extremely toxic bis(trimethylsilyl)sulfide (TNS)2S as the starting materials. See for example US 7,118,627 B2. The use of (TNS)2S not only bears high costs, but also requires careful handling of the chemicals in a glove box or in special facilities, and the odour produced is quite toxic and malodorous.

In addition, the widely used synthetic method employs a typical wet chemistry technique, which is known to limit the scale of materials production. The production of such PbS nanoparticles in large scale would significantly further elevate manufacturing costs, considering the high cost of the raw materials, the air sensitive chemicals handlings and related special facilities engineering, and the low scale production capability of single batch reactions.

The typical wet chemistry technique employs further sophistic glass wears to which physicists and engineers are not quite familiar to.

Therefore, there is a need to develop a synthetic protocol that produces high quality Pb chalcogenide nanocrystals with the capacity for large scale production by using a greener and inexpensive precursor material, in order to keep or even further promote the momentum of the currently intensive studies of photovoltaic devices by using colloidal Pb chalcogenide nanoparticles.

It is therefore an object of the present invention to provide a method for producing high crystalline Pb chalcogenide nanoparticles which overcomes the difficulties of the prior art. Especially, the method shall allow easy and safe productions of the Pb chalcogenide nanoparticles with especially safe starting materials which allow large scale production. Further, it is an object to provide improved high crystalline Pb chalcogenide nanoparticles, preferably having a particle size of about 100 nanometer, which can be successfully used in semiconducting or optoelectronic devices.

The object is achieved by a method for preparing highly crystalline Pb chalcogenide nanoparticles, comprising the steps: a) reacting Pb precursor and at least one organic C₁₄-C₂₂ acid in a stabilizing solvent to prepare a first solution containing Pb carboxylate, b) preparing a second solution of a sulphur-containing material in the stabilizing solvent, c) preparing a mixture of the first and the second solution and optionally additional stabilizing solvent, and transferring the mixture obtained in step c) to a teflon-lined autoclave and keeping the mixture in the closed autoclave at a temperature of about 30°C-150°C, preferably 50-120°C.

The organic C₁₄-C₂₂ acid can be, for example, oleic acid, myristic acid or therelike, wherein oleic acid is preferred.

Preferably, the Pb chalcogenide is PbS, PbSeS or PbSe.

Even preferred, the stabilizing solvent is octadecene and/or trialkyl phosphine, such as trioctyl phosphine, wherein octadecene is preferred.

In one preferred embodiment, the sulphur-containing material is S, thiourea and/or thioacetamide.

The mixture prepared in step c) additionally contains preferably a reducing agent, preferably benzothiazole disulphide (MBTS).

The temperature in the teflon lined autoclave in step d) is preferably kept between 50-120°C.

The mixture is kept in the teflon-lined autoclave in step d) preferably for 10-60 minutes.

After step d) the highly crystalline nanoparticles obtained are preferably optionally washed and then isolated.

In a most preferred embodiment, the mixture in step d) in the teflon-lined autoclave is not stirred.

Preferably, the feed molar ratio of organic acid: PbO is higher than 2:1, preferably 2:1 1 to 20:1, more preferably 10:1.

Even preferred, the feed molar ratio of Pb:S is 10:1-1:1, preferably 5:1-3:1, more preferably 4:1.

Another object is achieved by highly crystalline Pb chalcogenide nanoparticles which are obtainable according to a method of the present invention. In a preferred embodiment, these nanoparticles have a particle size of 5-130 µm, preferably 10-110 µm, more preferably about 100 µm.

Finally, the highly crystalline Pb chalcogenide nanoparticles according to the present invention can be successfully used in optoelectronic device applications, including high-detectivity radiation sensing in the infrared, visible, and ultraviolet, highly emissive electroluminescent devices for lightning and displays, and in solution-processed lasers and photovoltaics.

It was surprisingly found by the method of the present invention that this method is a successful approach for synthesis of Pb chalcogenide nanoparticles in a large scale. Moreover, the inventive method does not require special handling tools as the starting materials used are stable in air and are substantially non-toxic.

The inventive method relies to a so called solvothermal method using an inexpensive precursor source. With the inventive method highly crystalline Pb chalcogenides, preferably PbS, can be successfully obtained having a particle size of about 100 nm using the solvothermal synthesis instead of well known wet chemistry approaches.

In the present invention, the term "highly crystalline" means a crystalinity of above 90%, preferably above 95%. In a most preferred embodiment, the nanoparticles obtained are single crystals.

The nanoparticles obtained also show improved solution processability compared to nanoparticles obtained by other methods known in the art. Thus, this development will represent a big step forward on the journey to low cost and high reproducibility of Pb chaclogenide nanoparticles for optoelectronic device applications: including high-detectivity radiation sensing in the infrared, visible, and ultraviolet; in highly emissive electroluminescent devices for lighting and displays; and in solution-processed lasers and photovoltaics.

Further features and advantages of the subject-matter of the present invention can be taken from the following detailed description of preferred embodiments taken together with the drawings, wherein
Figure 1 illustrates absorption spectra of PbS nanocrystals obtained from three different batches with varying amounts of oleic acid;
Figure 2 illustrates the absorption spectra of PbS nanoparticles obtained from two different batches using thioacetamide and elemental S as sulphur containing starting materials;
Figure 3 illustrates absorption spectra for PbS nanocrystals using varying Pb:S molar feed ratios, prepared at different temperatures;
Figure 4 illustrates absorption spectra of different PbS nanoparticles, obtained by using four different batches, the method carried out at different temperatures;
Figure 5 illustrates absorption spectra from five different PbS nanoparticles, obtained by variation of reaction time;
Figure 6 shows X-ray diffraction (XRD) patterns of PbS prepared by solvothermal reaction, wherein Figure 6(a) was carried out with reducing agent MBTS, Figure 6(b) shows the result without using MBTS, and Figure 6(c) corresponds to the JCPDS database number 05-0592 for cubic PbS;
Figure 7(a) shows a TEM image of single-crystal PbS, prepared according to the method of the present invention, and Figures 7(b) and (c) show SAED patterns of these single crystal PbS nanoparticles.

### Experimental details

### Materials

All chemicals were purchased from Aldrich, if not specified otherwise, and were used as received.

Pb source compound: lead oxide (PbO, 99.9%)

S-source compound: elemental sulphur (Anachemia, powder) and thioacetamide (TAA, 99.0%)

Acid: oleic acid (OA, tech. 90%)

Reducing agent: 2,2-dithiobisbenzothiazole (MBTS, 99%).

### Typical synthesis of PbS NPs

A method for producing highly crystalline PbS nanoparticles according to the present invention can be divided into three main steps. The same principles can be also applied for preparing other Pb chalcogenides. Firstly, a Pb stock solution is prepared, wherein PbO, OA and ODE (octadecene) is loaded in a 50 ml three-neck reaction flask at room temperature. After degassing, the mixture is heated to 120°C with stirring under vacuum for one hour to form a clear precursor of lead oleate (Pb(OA)₂) and subsequently cooled to ambient temperature.

Secondly, a sulphur stock solution is prepared, wherein elemental S or TAA is sonicated with ODE for one hour while keeping the temperature at room temperature, to form a milky S source solution.

The two stock solutions prepared above can be preserved under nitrogen atmosphere in sealed vials and used as necessary.

Thirdly, a mixture of respective amounts of Pb-stock solution, S-stock solution, optionally additional ODE and further optionally reducing agent (such as MBDS) is prepared and transferred to a teflon lined autoclave, in which the growth of the nanocrystals is carried out at either room temperature or elevated temperature.

Preferably, the mixture in the autoclave is heated up at a constant rate of 10°C/minute, followed by an isothermal stage at 50°C, 80°C, 100°C, and 120°C for 30 and 60 minutes. Subsequently, the mixture is quenched to ambient temperature. Afterwards, 30 µl of each sample is dispersed into 3 ml toluene for the measurement of the optical properties of the growing PbS ensemble. Absorption spectra are collected on UV-3600 UV/Vis/NIR spectrometer (Shimadzu, Japan) using a 1-nm data collection interval and scan rate of 600 nm/minute, while photoemission experiments are performed on a RF-5301PC spectrometer (Shimadzu, Japan), with a 450W Xe lamp as the excitation source, an excitation wavelength of 500 nm (if not specified), an increment of data collection of 2 nm, and the slits for excitation and emission of 3 nm. If necessary, aliquote are purified by precipitation twice in toluene/methanol. Afterwards, the purified powders are dispersed in toluene with a proper concentration.

### Synthesis of single crystal PbS nanomaterials having a size of about 100 nm

After mixing the S-stock into the Pb-stock solutions with reducing agent (MBDS) in a feed molar ratio of Pb:S:MBDS=4:1:1 in the teflon lined autoclave, the stainless steel chamber was screwed well with a lid and placed in an oven. Afterwards, the oven was heated up by a rate of about 10°C/minutes from room temperature to 100°C. In order to acquire the desired 100 nm size, the growth temperature of 100°C was controlled inside the oven and kept for 60 minutes. Afterwards, 50 µl of each sample was dispersed into 3 ml of toluene for the measurement of the optical properties.

### PbS nanoparticles purification for XRD and TEM

A mixture of toluene and methanol was added to as-synthesized-PbS nanoparticles to precipitate the nanoparticles. After centrifugation (4000 rpm for 10 minutes), the supernatant was decanted and toluene was added to disperse the PbS nanoparticles with shacking. Such a process of purification was carried out for three times. For transmission electron microscopy (TEM) characterization, a purified sample stored in toluene was deposited on a carbon-coated copper grid and was studied on a JEM-2100F (JEOL/Japan) electron microscope operating at 200 kV and equipped with a Gatan UltraScan 1000 CCD camera. Powder X-ray diffraction (XRD) patterns were recorded at room temperature on a XRD-7000 (Shimadzu, Japan) X-ray diffractometer using Cu Kα radiation in a θ-θ mode. The generator was operated at 40 kV and 40 mA, and data were collected between 5° and 80° in 2 θ with a step size of 0.1° and a counting time of 5 seconds per step. XRD samples were prepared by depositing purified nanoparticles on low-background quartz plates.

### Results

The present invention addresses a solvothermal synthetic method and a low temperature approach to produce large scale crystalline, preferably single crystal PbS nanoparticles in a stabilizing solvent, in the present case is octadecene.

In a first part, various synthetic parameters including acid-to-Pb-to-S feed molar ratios, reacting temperature, treatment time, presence of reducing agent, different S source compounds, etc., were investigated. This discussion section is substantially based on the use of the absorption spectra from each batch of the reaction.

In a second part, the structures and characterizations of PbS nanoparticles by XRD and TEM are discussed.

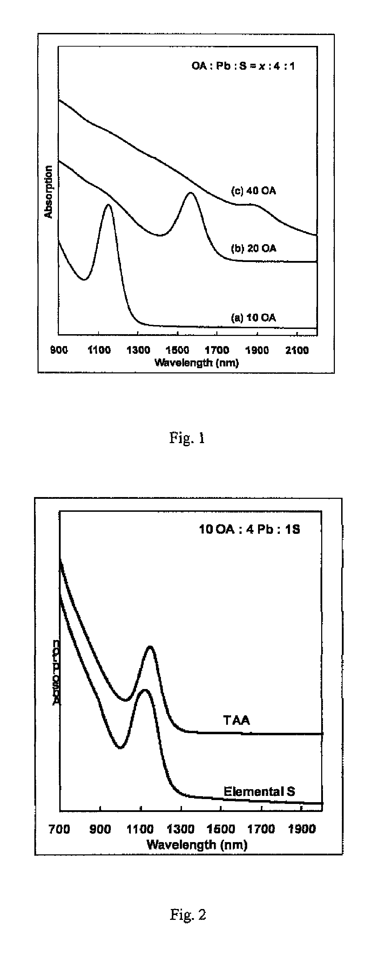

It was found that the acid-to-Pb feed molar ratio has strong influence on the formation of PbS nanoparticles, and also the amount of oleic acid (OA) plays an important role effecting the solubility of the resulting nanoparticles in the reaction medium. The larger the amount of OA, the larger the PbS nanocrystals, due to a better reaction medium solubility. Further, it was found that the lead oxide precursor was not able to dissolve completely in the form of lead oleate in octadecene (ODE) when the feed molar ratio of OA:PbO was smaller than 2:1. An excess of at least twofold molar ratio of acid is preferably used to synthesize nanoparticles with narrow size distribution and tunable sizes from one synthetic batch. Figure 1 shows the absorption peak positions of PbS nanocrystals at different molar ratio of oleic acid, wherein each reaction was carried out at a constant parameters of Pb:S=4:1, concentration [s] = 50 mmol/kg, reaction time of 30 minutes and reaction temperature of 100°C.

Two different sulphur sources, namely thioacetamide (TAA) and elemental S were investigated to synthesize PbS nanoparticles. The absorption spectra from these two batches are shown in Fig. 2, when each reaction was carried out at constant parameters of feed molar ratios OA:Pb:S=10:4:1, concentration of [S] = 50 mmol/kg, reaction of 30 minutes and reaction temperature of 100°C. TAA has often been used to synthesize PbS nanoparticles with various morphologies in aqueous media. With elemental S as the S source, the reducing agent was used together to enhance S reactivity. With the typical synthesis conditions but the two different S precursors, several reaction batches were prepared. It was found that the two S precursor compounds have different reactivity, wherein TAA shows a higher activity than elemental S. The formation of nanoparticles started at 50°C with TAA, whereas similar good absorption spectrum was observed using elemental S with MBTS at 100°C.

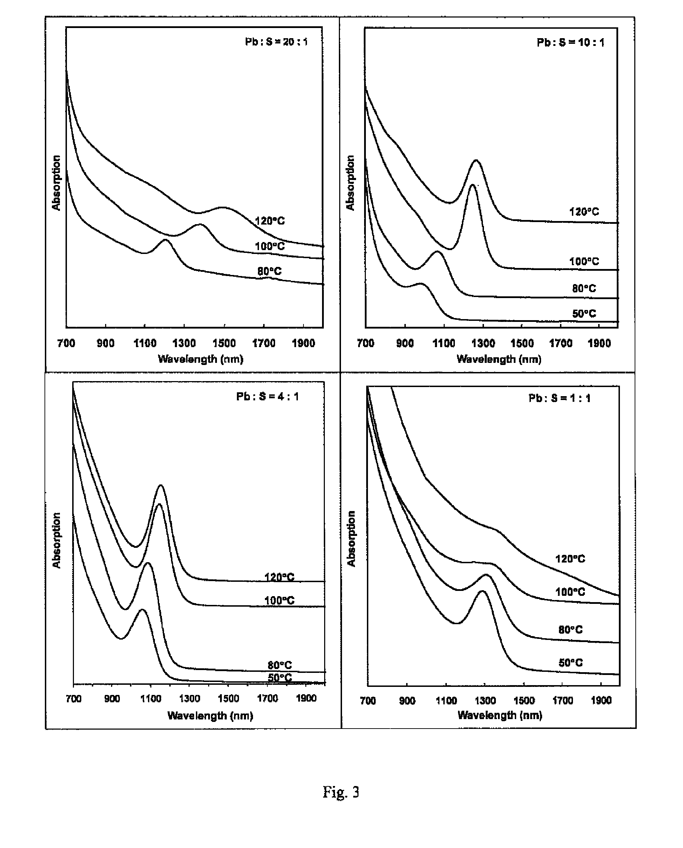

For investigating the influence of the feed molar ratio Pb:S, different batches with Pb:S = 20:1, 10:1, 4:1 1 and 1:1 using typical synthetic conditions were produced. Fig. 3 shows the absorption spectra of the nanocrystals obtained for 15 different batches with a concentration of [S] = 50 mmol/kg and a reaction time of 30 minutes. After mixing of the Pb precursor and S precursor solutions at room temperature, the colour of the resulting solution changed from clear yellow to brown and then to black, indicating the presence of a nucleation/growth process of PbS nanoparticles. With a Pb:S = 20:1 feed molar ratio approach, the nanocrystals grew too fast, while for a molar ratio of lower than 1.:1 a very slow growth rate was observed. As the Pb:S feed molar ratio increases, the peak positions of the band gap absorption blue shifted, indicating a decrease of the PbS nanoparticle size. It can be also stated that in each of the feed molar ratios, the peak positions of the band gap absorption red-shifted with increase of the reaction temperature.

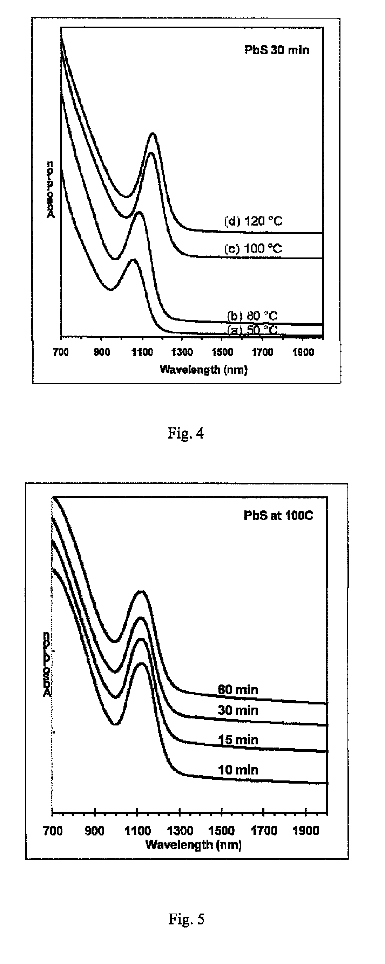

Fig. 4 illustrates the absorption spectra of PbS nanoparticles prepared at different temperatures of (a) 50°C, (b) 80°C, (c) 100°C and (d) 120°C. During the growth periods monitored up to 30 minutes the first exitonic absorption peaks exhibit relatively large red-shifts for the nanoparticles from the batch at 50°C and 80°C, as compared to that from the batches with 100°C and 120°C. The lower temperature can give a smaller size of NPs at the beginning growth of period; however, this mild temperature in spectrum (b) continues to grow at later growth period, corresponding to the absorption peak position at 1090 nm. Spectrum (c) shows the temporal evolution of the absorption of the growing NPs from the batch with 100°C growth.

During such a growth period of time increase, the resulting PbS NPs exhibit bandgap absorption with a small red-shift from 1090 nm to 1150 nm; the relatively small red-shift indicates unapparent growth in size of the PbS NPs. This can be explained that the higher temperature lead to a higher reaction rate to supply a large number of nuclei at the beginning growth of period. The sources were almost consumed in nucleation stage and subsequently limited the development of growth. Moreover, each NP ensemble sampled at 100°C exhibits a single absorption peak with a high symmetry which suggests narrow size distribution.

The absorption spectra of Fig. 4 were obtained with a feed molar ratio OA:Pb:S = 10:4:1, a concentration of [S] of 50 mmol/kg and a reaction time of 30 minutes.

Fig. 5 illustrates absorption spectra of five different batches prepared under identical conditions of OA:Pb:S = 10:4:1, concentration of [S] of 50 mmol/kg and reaction temperature of 100°C, but four different times. All absorption peak positions are at about 1,120 nm.

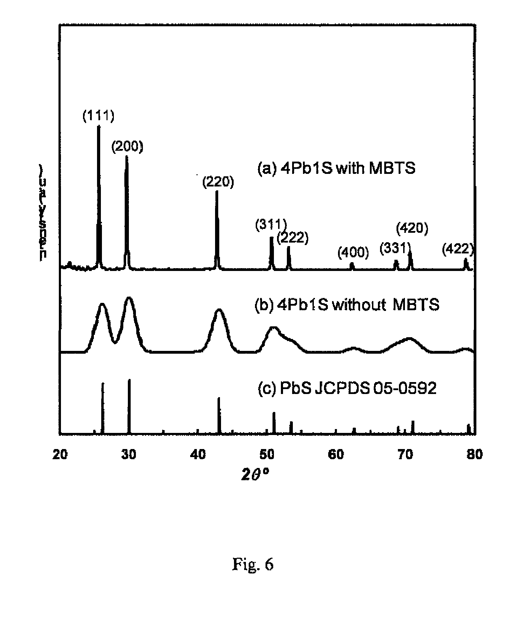

Figure 6 shows the thin-film powder X-ray diffraction (XRD) patterns of the 100°C and 60 min growth of PbS NPs with MS TB (Figure 6a), without MSTB (Figure 6b) and the corresponding JCPDS database no. 05-0592 for cubic PbS (Figure 6c). The reflection peaks of (111), (200), (220), (311), (222), (400), (331), (420) and (422) are clearly distinguished, and all these diffraction peaks can be perfectly indexed to a cubic PbS structure with a lattice parameter of a = 5.9362 A. The strong and narrow peaks indicate high crystallinity of the PbS NPs sample, whereas broader peaks appeared from small size crystalline PbS NPs sample. The crystal sizes of several samples were calculated using Scherrer's equation, B = λk/LcosΘ, where λ is the wavelength of Cu Kα radiation (0.15406 nm), Θ the Bragg angle, L the average crystal size, k a constant (k = 0.89), and B the full width at half maximum (FWHM) in radian unit. The NPs size is estimated from 10∼30 nm by using this Scherrer Equation with the FWHM of the diffraction peak (220). The highly crystalline single-crystal-size, ∼100 nm PbS NPs products were characterized by TEM analysis.

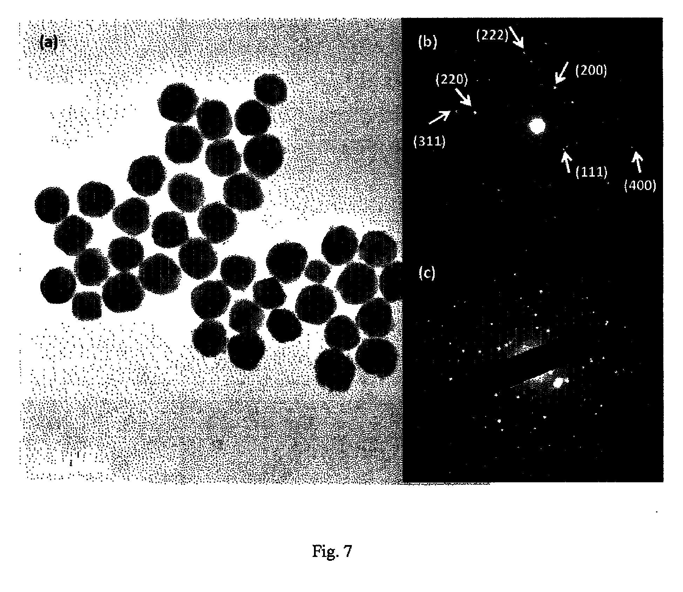

The morphologies and size of the prepared PbS NPs were examined by transmission electron microscope (TEM). Optimization of solvothermal treatment (reaction condition: feed molar ratio of OA : Pb : S : MBTS = 10 : 4 : 1 : 1, reaction temperature 100°C, reaction time 60 min, concentration of S = 50 mmol/kg) produced an average size of ca 100 nm and spherical shaped PbS NPs. The TEM image and SAED pattern of 100 nm single-size crystalline PbS NPs prepared by the solvothermal method at are shown in Figure 7(a). The SAED pattern shows a number of randomly and continuously bright spots, which are so close that they formed several fully concentric rings. These indicate that the product was consisted of nano-sized crystals with different orientations. Calculated interplanar spaces were compared with those of the JCPDS database no. 05-0592.¹¹ They correspond to the (111), (200), (220), (311), (222), (400) and (331) planes of the cubic PbS structure.

It was also surprisingly found that without using a reducing agent, smaller size PbS nanoparticles can be prepared.

Instead of using octadecene as stabilizing agent, also the use of alkylphosphines is possible. Using trioctylphosphine instead of octadecene, a higher reactivity is observed. Using trioctylphosphine in a higher amount, for example a mixture of 75 wt.% triocytylphosphine:25 wt.% octadecene, the activity of the reaction becomes that high that not only the reaction is quite violent, but also fabricates a large number of nuclei already in the first five minutes resulting in only small size nanoparticles obtained.

Lead chalcogenide nanocrystals with large exciton Bohr have radii of 18 nm for PbS and 47 nm for PbSe, which allows strong confinement to be achieved in relatively large structures. Therefore, PbS and PbSe may have properties of strong quantum confinement. Furthermore, these materials have a band gap of 0.28-0.41 eV and 300 K in the mid-infrared and have a small effective mass that have size-tunable near infrared emission. Thus, these materials are particularly interesting for NIR applications. In addition, the observation of optical gain and amplified spontaneous emission from these materials open the door to possible tunable infrared lasers, and multi-exciton variation in these materials may increase the efficiencies of future solar cells.

The features disclosed in the foregoing description, in the claims and in the accompanying drawings may both separately and in any combination be material for realizing the invention in diverse forms thereof.

## Claims

1. Method for preparing highly crystalline lead (Pb) chalcogenide nanoparticles, comprising the steps:
a) reacting Pb precursor and at least one organic C₁₄-C₂₂ acid in a stabilizing solvent to prepare a first solution containing Pb carboxylate,
b) preparing a second solution of a sulphur-containing material in the stabilizing solvent,
c) preparing a mixture of the first and the second solution and optionally additional stabilizing solvent, and
d) transferring the mixture obtained in step c) to a teflon-lined autoclave and keeping the mixture in the closed autoclave at a temperature of about 30°C-150°C, preferably 50-120°C.

2. Method according to claim 1, wherein the Pb chalcogenide is PbS, PbSeS or PbSe.

3. Method according to claim 1 or 2, wherein the stabilizing solvent is octadecene and/or trialkyl phosphine, such as trioctyl phosphine, wherein octadecene is preferred.

4. Method according to any of the preceding claims, wherein the sulphur-containing material is elemental S, thiourea and/or thioacetamide.

5. Method according to any of the preceding claims, wherein the mixture prepared in step c) additionally contains a reducing agent, preferably benzothiazole disulphide (MBTS).

6. Method according to any of the preceding claims, wherein the temperature in the teflon lined autoclave in step d) is kept between 50-120°C.

7. Method according to any of the preceding claims, wherein the mixture is kept in the teflon-lined autoclave in step d) for 10-90 minutes.

8. Method according to any of the preceding claims, wherein after step d) highly crystalline nanoparticles are optionally washed and then isolated.

9. Method according to any of the preceding claims, wherein the mixture in step d) in the teflon-lined autoclave is not stirred.

10. Method according to any of the preceding claims, wherein the feed molar ratio of organic acid: PbO is higher than 2:1, preferably 2:1 to 20:1, more preferably 10:1.

11. Method according to any of the preceding claims, wherein the feed molar ratio of Pb:S is 10:1-1:1, preferably 5:1-3:1, more preferably 4:1.

12. Method according to any of the preceding claims, wherein the Pb precursor is selected from the group consisting of lead oxide, lead (II) acetate, lead (II) nitrate, lead (II) chloride, lead (II) sulphate and mixtures thereof.

13. Highly crystalline Pb chalcogenide nanoparticles, obtainable according to a method of any of the claims 1-12.

14. Highly crystalline Pb chalcogenide nanoparticles according to claim 13 having a particle size of 5-130 nanometer, preferably 10-110 nanomater, preferably about 100 nanometer.

15. Use of highly crystalline Pb chalcogenide nanoparticles according to claim 13 in optoelectronic device applications including high-detectivity radiation sensing in the infrared, visible, and ultraviolet, highly emissive electroluminescent devices for lighting and display, and in solution-processed lasers and photovoltaics.
